# EUROPEAN PATENT SPECIFICATION

(11) **EP 3 014 084 B1**
(45) Date of publication and mention of the grant of the patent: **11.12.2019**
(21) Application number: 14817127.5
(22) Date of filing: 25.06.2014
(51) Int. Cl.: F02B 33/34, F02B 39/00, F02B 39/14, F01P 3/12, F02B 33/40, F02B 39/10, F04D 25/06, F04D 29/42, F04D 29/58, H02K 7/14, H02K 11/33

(54) **CHARGING APPARATUS FOR A COMBUSTION ENGINE**
LADEVORRICHTUNG FÜR EINE BRENNKRAFTMASCHINE
APPAREIL DE CHARGE POUR MOTEUR À COMBUSTION

(30) Priority: 28.06.2013 DE 102013010862
(43) Date of publication of application: 04.05.2016
(73) Proprietor: Borgwarner Inc., Auburn Hills, Michigan 48326 (US)
(72) Inventor: GRUNDMEIER, Ramona, 55595 Argenschwang (DE); SPINNER, Gerd, 55232 Alzey (DE); METZ, Dietmar, 67149 Meckenheim (DE)
(74) Representative: Peterreins Schley
(86) International application number: PCT/US2014/043988
(87) International publication number: WO 2014/210093

(56) References cited:
- EP-A1- 2 163 747
- WO-A1-2005/024202
- JP-A- 2004 270 533
- JP-A- 2012 062 777
- US-A- 4 955 352
- US-A1- 2002 134 082
- US-A1- 2006 081 226
- US-A1- 2007 036 664
- US-A1- 2007 169 747
- US-A1- 2010 266 430

## Description

The invention relates to a charging apparatus for a combustion engine as claimed in the preamble of claim 1.

In a known charging apparatus of this kind, the only cooling provided is air cooling which firstly is insufficient and secondly leads to a less compact construction of the charging apparatus. Prior art charging apparatuses are known, e.g., from JP 2012 062777 A, EP 2 163 747 A1 and WO 2005/024202 A1.

In contrast, the object of the present invention is to provide a charging apparatus as claimed in the preamble of claim 1 which allows for space-saving construction and improved cooling.

This object is achieved by the features of claim 1.

According to the invention, the power electronics circuit is arranged in a space-saving manner between the compressor housing rear wall and the electric motor which is provided adjacent to the compressor housing rear wall.

The dependent claims contain advantageous developments of the invention.

If the compressor housing rear wall is provided with a cooling jacket, this results in an extremely compact and cost-effective structure in which the electric motor, the bearing of the shaft of the electric motor and the power electronics circuit can advantageously be cooled at the same time by the cooling jacket which is provided.

In order to prevent an undesired transfer of heat from the charge air, it is also advantageous to insulate the compressor housing and the rear wall from the motor and from the power electronics circuit.

Therefore, the bearing, the motor coil and the power electronics circuit are preferably mounted on one component and are separated from the other components of the compressor according to the invention by suitable insulating measures.

Further details, advantages and features of the present invention can be found in the following description of exemplary embodiments with reference to the drawing, in which:
figure 1 is a schematically slightly simplified sectional illustration through a first embodiment of a charging apparatus according to the invention;
figure 2 is an illustration, which corresponds to figure 1, of a second embodiment of the charging apparatus according to the invention; and
figure 3 is a basic diagram of a combustion engine which can be provided with a charging apparatus according to the invention which corresponds to the first or the second embodiment.

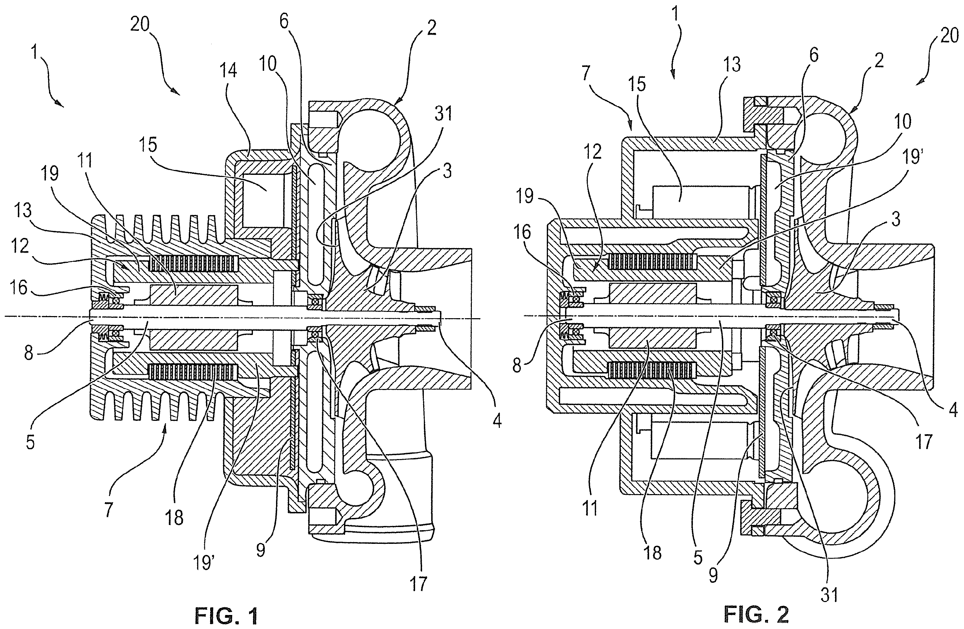

Figure 1 shows a first embodiment of a charging apparatus 20 comprising an electrically driven compressor. The compressor 1 has a compressor housing 2 in which a compressor wheel 3 is arranged. The compressor wheel 3 is mounted on one end 4 of a rotor shaft 5.

As is also illustrated in figure 1, the compressor housing 2 has a compressor housing rear wall 6 which is in the form of a compressor housing cover in the illustrated embodiment.

In this case, the compressor housing rear wall 6 is provided with a cooling jacket 10, preferably for cooling water, and is arranged behind the compressor wheel 3 and is fixed on the compressor housing 2 and closes said compressor housing in this way.

The compressor 1 also has an electric motor 7. The electric motor 7 comprises a shaft 8 which is connected to a rotor shaft 5. In the illustrated embodiment, the shaft 8 and the rotor shaft 5 are designed as an integral component, as is shown in detail in figure 1. In this case, the shaft 8 is in the form of a shaft stub which has a smaller outside diameter than the rotor shaft 5 and on which a bearing 16 is arranged. The end 4 of the rotor shaft 5 is likewise of reduced diameter in relation to the rotor shaft 5 and is fitted with a second bearing 17. As shown in figure 1, the bearing 16 is supported against a bearing section of a stator housing 13, whereas the bearing 17 is supported, by way of its outer ring, in a recess of the compressor housing rear wall 6.

A magnet 11 is also provided on the rotor shaft 5, said magnet interacting with a stator winding 12 which surrounds said magnet on the outside.

The embodiment of the compressor 1 according to figure 1 also has a dirt-protection cover 14 which is mounted on the stator housing 13 or on the compressor housing rear wall 6 and in which electronics components 15 of a power electronics circuit or electronics printed circuit board 9 are arranged.

As illustrated in figure 1, the power electronics circuit 9 is arranged between the compressor housing rear wall 6 and the electric motor 7 or the dirt-protection cover 14. To this end, the power electronics circuit 9 can be firmly clamped, for example, between the dirt-protection cover 14 and the compressor housing rear wall 6, or else mounted, for example fixedly adhesively bonded, on one of the two parts.

This arrangement results in the advantage that the power electronics circuit 9 is arranged adjacent to the cooling jacket 10, this considerably improving the cooling effect of said cooling jacket with respect to the power electronics circuit 9.

A thermally conductive paste can be provided between the power electronics circuit 9 and the cooling jacket 10 or the compressor housing rear wall 6 in which the cooling jacket 10 is arranged.

Figure 2 shows a second embodiment of a charging apparatus 20 according to the invention, in which all of the components which correspond to the embodiment in figure 1 are identified by the same reference numerals.

In this case, the compressor housing rear wall 6 of the embodiment according to figure 2 is an end wall of the stator housing 13 in which the bearing 17 is arranged. In this embodiment, the stator housing 13 likewise has an inner cooling arrangement and therefore a cooling jacket 10, wherein, in this embodiment too, the power electronics circuit 9 is arranged between the compressor housing rear wall 6 and the electric motor 7 or its stator housing 13, and therefore enjoys the same advantages of a compact construction and improved cooling of the components.

Since the embodiment according to figure 2 is connected directly to the compressor housing 2 by way of its stator housing 13, for example by means of a screw connection, said embodiment does not have a dirt-protection cover either.

The power electronics circuit 9 can, like that in figure 1, be firmly clamped in the stator housing 13 or be mounted in some other suitable way. The power electronics circuit 9 can comprise all of the required components for fulfilling the function of an electronic commutator. Said power electronics circuit is, in particular, a control circuit comprising transistors or so-called MOSFETs. The power electronics circuit 9 can also comprise sensors, in particular Hall sensors. The electronic components 15 comprise, in particular, a capacitor, amongst others.

The two embodiments described with reference to figures 1 and 2 have an iron ring 18 which the stator winding provides between its winding heads 19, 19'.

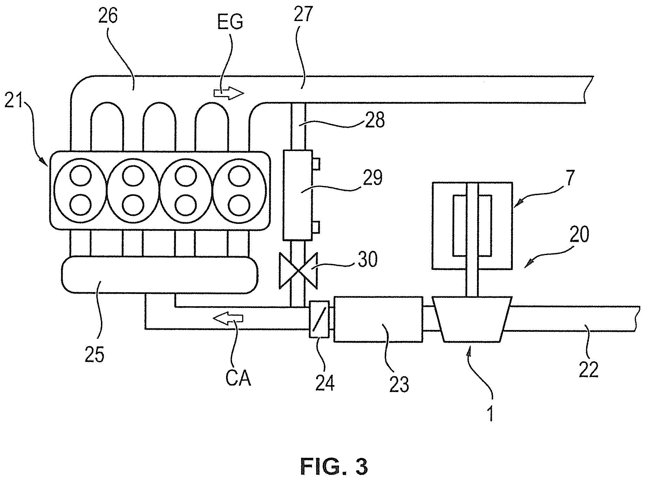

Figure 3 is a schematically highly simplified illustration of a combustion engine 21, for example in the form of a (diesel or petrol) internal combustion engine. The combustion engine 21 has an intake line 22 in which the compressor 1 of the charging apparatus 20 is arranged, said compressor being driven by the electric motor 7. A charge air cooler 23, followed by a throttle 24, can be arranged downstream of the compressor 1 in the intake line 22. The compressed air, which is symbolized by the arrow CA, from the compressor 1 is supplied to an intake manifold 25, and the cylinders of the combustion engine 21 are supplied with the compressed air from said intake manifold.

The exhaust gas EG is supplied to an exhaust gas line 27 via an exhaust gas manifold 26.

In the particularly preferred embodiment which is illustrated in figure 4, the internal combustion engine 21 is also provided with an exhaust gas return line 28 in which an exhaust gas cooler 29 and a valve 23 are arranged. However, said exhaust gas return line 28, together with its components 29 and 30, is not mandatory, but rather constitutes merely a particularly preferred embodiment.

In addition to the above written description of the invention, reference is hereby explicitly made, for additional disclosure thereof, to the diagrammatic illustration of the invention in figures 1 to 3.

### LIST OF REFERENCE SIGNS

- 1: Compressor
- 2: Compressor housing
- 3: Compressor wheel
- 4: End
- 5: Rotor shaft
- 6: Compressor housing rear wall
- 7: Electric motor, in particular a brushless DC motor
- 8: Shaft
- 9: Power electronics circuit/electronics printed circuit board
- 10: Cooling jacket
- 11: Magnet
- 12: Stator winding
- 13: Stator housing
- 14: Dirt-protection cover
- 15: Electronics components
- 16, 17: Bearings
- 18: Iron ring
- 19, 19': Winding heads
- 20: Charging apparatus
- 21: Combustion engine
- 22: Intake line
- 23: Charge air cooler
- 24: Throttle
- 25: Intake manifold
- 26: Exhaust gas manifold
- 27: Exhaust gas line
- 28: Exhaust gas return line
- 29: Exhaust gas cooler
- 30: Valve
- 31: Compressor wheel rear side
- CA: Compressed air
- EG: Exhaust gas

## Claims

1. A charging apparatus (20) for a combustion engine (21)
- comprising an electrically driven compressor (1) which has a compressor housing (2),
• in which a compressor wheel (3) is arranged, said compressor wheel being mounted on one end (4) of a rotor shaft (5), and
• which has a compressor housing rear wall (6) which is adjacent to a compressor wheel rear side (31);
- comprising an electric motor (7)
• which is mounted on the compressor housing (2), and
- comprising a power electronics circuit (9),
wherein
- the power electronics circuit (9) is arranged between the compressor housing rear wall (6) and the electric motor (7), and **characterised in that** the compressor housing rear wall (6) is provided with a cooling jacket (10).

2. The charging apparatus as claimed in claim 1, wherein a magnet (11) is arranged on the rotor shaft (5).

3. The charging apparatus as claimed in claim 2, wherein a stator winding (12) surrounds the magnet (11) on the outside.

4. The charging apparatus as claimed in claim 2 or 3, **characterized by** a stator housing (13) which surrounds the stator winding (12) on the outside.

5. The charging apparatus as claimed in one of claims 1 to 4, **characterized by** a dirt-protection cover (14) which is arranged on the compressor housing rear wall (6).

6. The charging apparatus as claimed in one of claims 1 to 5, wherein the power electronics circuit (9) is arranged coaxially in relation to the rotor shaft (5).

7. The charging apparatus as claimed in one of claims 1 to 6, wherein the compressor housing rear wall (6) is in the form of a housing cover.

8. The charging apparatus as claimed in one of claims 1 to 6, wherein the compressor housing rear wall (6) is formed by an end wall of the electric motor (7).

9. The charging apparatus as claimed in one of claims 1 to 8, wherein the power electronics circuit (9) is arranged adjacent to the cooling jacket (10).

10. The charging apparatus as claimed in one of claims 1 to 9, wherein a thermally conductive layer, in particular in the form of a thermally conductive paste, is arranged between the power electronics circuit (9) and the cooling jacket (10).

11. The charging apparatus as claimed in one of claims 1 to 10, wherein the power electronics circuit (9), a bearing (16, 17) of the shaft (5, 8) and the stator winding (12) are mounted on one component.

12. The charging apparatus as claimed in one of claims 1 to 11, wherein the combustion engine is in the form of an internal combustion engine or fuel cell.

## Patentansprüche

1. Aufladevorrichtung (20) für eine Brennkraftmaschine (21)
- umfassend einen elektrisch angetriebenen Verdichter (1), der ein Verdichtergehäuse (2) aufweist,
• in dem ein Verdichterrad (3) angeordnet ist, das auf einem Ende (4) einer Rotorwelle (5) befestigt ist, und
• das eine einem Verdichterradrückseite (31) benachbarte Verdichtergehäuserückwand (6) aufweist;
- umfassend einen Elektromotor (7),
• der am Verdichtergehäuse (2) befestigt ist, und
- umfassend eine Leistungselektronikschaltung (9),
wobei,
- die Leistungselektronikschaltung (9) zwischen der Verdichtergehäuserückwand (6) und dem Elektromotor (7) angeordnet ist, und
**dadurch gekennzeichnet, dass** die Verdichtergehäuserückwand (6) mit einem Kühlmantel (10) versehen ist.

2. Aufladevorrichtung nach Anspruch 1, wobei ein Magnet (11) auf der Rotorwelle (5) angeordnet ist.

3. Aufladevorrichtung nach Anspruch 2, wobei eine Statorwicklung (12) den Magneten (11) außen umgibt.

4. Aufladevorrichtung nach Anspruch 2 oder 3, **gekennzeichnet durch** ein Statorgehäuse (13), das die Statorwicklung (12) außen umgibt.

5. Aufladevorrichtung nach einem der Ansprüche 1 bis 4, **gekennzeichnet durch** einen Schmutzschutzabdeckung (14), der an der Verdichtergehäuserückwand (6) angeordnet ist.

6. Aufladevorrichtung nach einem der Ansprüche 1 bis 5, wobei die Leistungselektronikschaltung (9) koaxial zur Rotorwelle (5) angeordnet ist.

7. Aufladevorrichtung nach einem der Ansprüche 1 bis 6, wobei die Verdichtergehäuserückwand (6) als Gehäusedeckel ausgebildet ist.

8. Aufladevorrichtung nach einem der Ansprüche 1 bis 6, wobei die Verdichtergehäuserückwand (6) von einer Stirnwand des Elektromotors (7) gebildet wird.

9. Aufladevorrichtung nach einem der Ansprüche 1 bis 8, wobei die Leistungselektronikschaltung (9) benachbart zum Kühlmantel (10) angeordnet ist.

10. Aufladevorrichtung nach einem der Ansprüche 1 bis 9, wobei zwischen der Leistungselektronikschaltung (9) und dem Kühlmantel (10) eine Wärmeleitschicht, insbesondere in Form einer Wärmeleitpaste, angeordnet ist.

11. Aufladevorrichtung nach einem der Ansprüche 1 bis 10, wobei die Leistungselektronikschaltung (9), eine Lagerung (16, 17) der Welle (5, 8) und die Statorwicklung (12) auf einem Bauteil montiert sind.

12. Aufladevorrichtung nach einem der Ansprüche 1 bis 11, wobei die Brennkraftmaschine als Verbrennungsmotor oder Brennstoffzelle ausgebildet ist.

## Revendications

1. Appareil de charge (20) pour un moteur à combustion (21),
- comprenant un compresseur entraîné électriquement (1) qui a un carter de compresseur (2),
• dans lequel une roue de compresseur (3) est agencée, ladite roue de compresseur étant montée sur une extrémité (4) d'un arbre de rotor (5), et
• qui a une paroi arrière de carter de compresseur (6) qui est adjacente à un côté arrière de roue de compresseur (31);
- comprenant un moteur électrique (7)
• qui est monté sur le carter de compresseur (2), et
- comprenant un circuit d'électronique de puissance (9), dans lequel
- le circuit d'électronique de puissance (9) est agencé entre la paroi arrière de carter de compresseur (6) et le moteur électrique (7), et
**caractérisé en ce que**
la paroi arrière de carter de compresseur (6) est pourvu d'une chemise de refroidissement (10).

2. Appareil de charge selon la revendication 1, dans lequel un aimant (11) est agencé sur l'arbre de rotor (5).

3. Appareil de charge selon la revendication 2, dans lequel un enroulement de stator (12) entoure l'aimant (11) sur l'extérieur.

4. Appareil de charge selon la revendication 2 ou 3, **caractérisé par** un carter de stator (13) qui entoure l'enroulement de stator (12) sur l'extérieur.

5. Appareil de charge selon l'une des revendications 1 à 4, **caractérisé par** un couvercle de protection anti-poussière (14) qui est agencé sur la paroi arrière de carter de compresseur (6).

6. Appareil de charge selon l'une des revendications 1 à 5, dans lequel le circuit d'électronique de puissance (9) est agencé coaxialement par rapport à l'arbre de rotor (5).

7. Appareil de charge selon l'une des revendications 1 à 6, dans lequel la paroi arrière de carter de compresseur (6) est sous la forme d'un couvercle de carter.

8. Appareil de charge selon l'une des revendications 1 à 6, dans lequel la paroi arrière de carter de compresseur (6) est formée par une paroi d'extrémité du moteur électrique (7).

9. Appareil de charge selon l'une des revendications 1 à 8, dans lequel le circuit d'électronique de puissance (9) est agencé de façon adjacente à la chemise de refroidissement (10).

10. Appareil de charge selon l'une des revendications 1 à 9, dans lequel une couche thermiquement conductrice, en particulier sous la forme d'une pâte thermiquement conductrice, est agencée entre le circuit d'électronique de puissance (9) et la chemise de refroidissement (10).

11. Appareil de charge selon l'une des revendications 1 à 10, dans lequel le circuit d'électronique de puissance (9), un palier (16, 17) de l'arbre (5, 8) et l'enroulement de stator (12) sont montés sur un composant.

12. Appareil de charge selon l'une des revendications 1 à 11, dans lequel le moteur à combustion est sous la forme d'un moteur à combustion interne ou d'une pile à combustible.
